# EUROPÄISCHE PATENTSCHRIFT

(11) **EP 1 042 787 B1**
(45) Veröffentlichungstag und Bekanntmachung des Hinweises auf die Patenterteilung: **02.03.2005**
(21) Anmeldenummer: 98955299.7
(22) Anmeldetag: 01.12.1998
(51) Int. Cl.: H01L 21/00

(54) **HALTEVORRICHTUNG**
HOLDING DEVICE
DISPOSITIF DE RETENUE

(30) Priorität: 23.12.1997 CH 295197
(43) Veröffentlichungstag der Anmeldung: 11.10.2000
(73) Patentinhaber: Unaxis Balzers Aktiengesellschaft, 9496 Balzers (LI)
(72) Erfinder: STAUSS, Peter, A-6800 Feldkirch (AT); KERSCHBAUMER, Jörg, A-6800 Feldkirch (AT)
(74) Vertreter: Wagner, Wolfgang, Dr. Phil., Dipl.-Phys.
(86) Internationale Anmeldenummer: PCT/CH1998/000505
(87) Internationale Veröffentlichungsnummer: WO 1999/034414

(56) Entgegenhaltungen:
- EP-A- 0 452 779
- EP-A- 0 489 439
- EP-A- 0 777 264
- EP-A- 0 807 960
- US-A- 5 611 865
- DATABASE WPI Section PQ, Week 9626 Derwent Publications Ltd., London, GB; Class P81, AN 96-258362 XP002094844 -& RU 2 047 197 C (VAVILOV GOI RES CENTRE) , 27. Oktober 1995 in der Anmeldung erwähnt

## Beschreibung

Die Erfindung betrifft eine Haltevorrichtung, wie sie in Vakuumanlagen eingesetzt werden. Sie dient dazu, z. B. in einer Zwischenkammer nach Uebernahme eines scheibenförmigen Werkstücks von einem Transportmechanismus in einer Uebergabeposition, in der sich ein Hubtisch derselben z. B. in einer unteren Endposition befindet, dasselbe in eine Bearbeitungsposition zu heben, indem der Hubtisch eine Hubbewegung in eine obere Endposition ausführt. In der Bearbeitungsposition liegt die Oberseite des Werkstücks in einer Prozesskammer und kann einem Bearbeitungsschritt unterworfen werden. Nach abgeschlossener Bearbeitung senkt der Hubtisch das Werkstück wieder in die Uebergabeposition ab, wo es wiederum vom Transportmechanimus übernommen werden kann. Eine entsprechende Vakuumanlage ist in der EP-A-0 343 530 beschrieben.

Bei Haltevorrichtungen dieser Art ist es erwünscht, dass der Stützring, auf den das Werkstück in der Uebergabeposition aufgelegt wird, gegenüber der Auflageplatte, auf der es in der Bearbeitungsposition aufliegt und über welche es beheizt oder gekühlt wird, möglichst genau zentriert ist. Dadurch können die Ausnehmungen am Rand der Auflageplatte, welche für die Stützen des Stützrings notwendig sind, klein gehalten werden, und die Bearbeitung des Werkstücks wie Beschichtung, Heizung oder Kühlung oder eine eventuelle sonstige Einwirkung der Auflageplatte auf das Werkstück erfolgt gleichmässig.

Eine bekannte gattungsgemässe Haltevorrichtung ist in der EP-A-0 452 779 beschrieben. Dort ist der Stützring als die Auflageplatte unmittelbar umgebender Ring ausgebildet. Da zwischen den beiden wegen allfälliger unterschiedlicher Wärmedehnungen ein bestimmter radialer Abstand vorgesehen sein muss, ist bei diesem Aufbau eine genaue Zentrierung des Stützringes bezüglich der Achse der Auflageplatte nicht gegeben. Da der Klemmring bezüglich des Stützrings zentriert ist, ist er ebenfalls bezüglich der Auflageplatte zwangsläufig ungenau zentriert.

Hier soll die Erfindung Abhilfe schaffen. Die Erfindung, wie sie im Anspruch 1 gekennzeichnet ist, schafft eine Haltevorrichtung, bei der Auflageplatte, Stützring und Klemmring bezüglich einer gemeinsamen Achse durch eine Zentriervorrichtung zentriert werden, deren Funktion durch unterschiedliche Wärmedehnung der besagten Teile nicht beeinträchtigt wird, und welche notwendige gegenseitige axiale Verschiebungen derselben nicht behindert.

Eine im grundsätzlichen Funktionsprinzip der vorgeschlagenen entsprechende, gegen Wärmedehnung unempfindliche Zentrierung ist für die Halterung einer Linse in der RU-C-2 047 197 beschrieben, wo an einem Gehäuse verankerte radiale Plättchen in entsprechende radiale Nuten an der Fassung der Linse eingreifen. Bei dieser Halterung ist jedoch keine gegenseitige axiale Verschiebung der Teile vorgesehen.

Die durch die Erfindung erreichten Vorteile liegen vor allem darin, dass eine konzentrische Positionierung des scheibenförmigen werkstücks auf der Auflageplatte sichergestellt werden kann und wegen der genauen Zentrierung des Klemmrings bezüglich der Auflageplatte und damit des Werkstücks der Randausschuss sehr gering ist. Die Haltevorrichtung ist besonders geeignet für Werkstücke wie Speicherplatten, z. B. Festplatten, magnetooptische Speicherplatten, CDs und vor allem Halbleiter-Wafer

Im folgenden wird die Erfindung anhand von Figuren, welche lediglich ein Ausführungsbeispiel zeigen, näher erläutert. Es zeigen
- Fig. 1: in perspektivischer Explosionsdarstellung einen herausgeschnittenen Sektor einer erfindungsgemässen Haltevorrichtung und
- Fig. 2: rechts einen ersten radialen Schnitt durch eine erfindungsgemässe Haltevorrichtung in einer unteren Endstellung, in der das Werkstück übergeben werden kann und links einen entsprechenden zweiten radialen Schnitt durch die gleiche erfindungsgemässe Haltevorrichtung in der oberen Endstellung, in der das Werkstück bearbeitet werden kann.

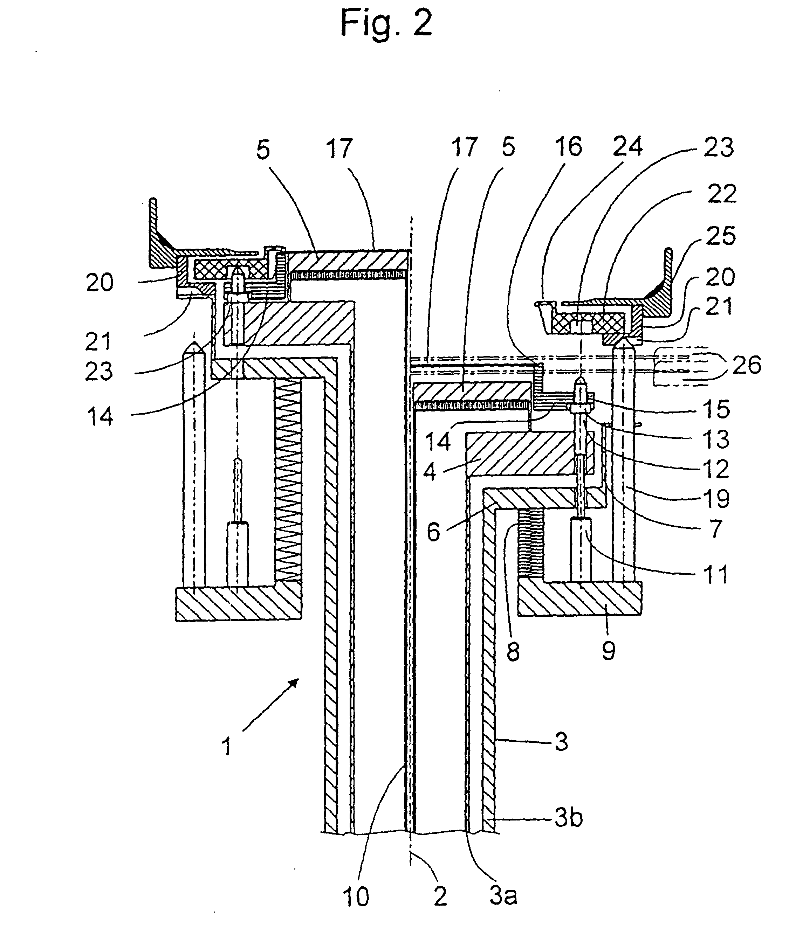

Die Haltevorrichtung umfasst (s. vor allem Fig. 2 rechts) einen Hubtisch 1, welcher um eine Achse 2 im wesentlichen rotationssymmetrisch ausgebildet ist mit einem Doppeltragrohr 3, das mittels einer entsprechenden nicht dargestellten Einrichtung parallel zur Achse 2 heb- und senkbar ist und dessen Innenrohr 3a eine Basisplatte 4 trägt, auf welcher eine Auflageplatte 5 befestigt ist, während das Aussenrohr 3b einen Ring 6 trägt mit einem Mitnehmerkragen 7 an seinem Aussenrand, welcher Ring die Basisplatte 4 konzentrisch mit Abstand umgibt. Die Unterseite des Rings 6 ist durch einen das Doppeltragrohr 3 umgebenden Metallbalg 8 mit dem Rand einer Oeffnung in einer ortsfesten Wand 9, durch welche das besagte Doppeltragrohr geführt ist, gasdicht verbunden. Die Auflageplatte 5 ist je nach der Vakuumkammer, für die die Vorrichtung gedacht ist, heizbar oder kühlbar oder beides. Ihre Form richtet sich nach der des zu bearbeitenden Werkstücks. Gewöhnlich wird sie wie dargestellt rund sein, doch sind auch andere Formen möglich, so kann sie z. B. rechteckig sein. In ihrem Zentrum mündet eine Leitung 10, durch welche Gas eingeleitet werden kann.

Ueber drei Stützen 11, deren Positionen ein gleichseitiges Dreieck bilden, in dessen Zentrum die Achse 2 liegt, sind Zentrierstifte 12, vorzugsweise aus nichtleitendem, insbesondere keramischem Material in der unteren Endposition an der Wand 9, also ortsfest abgestützt. Die Stütze 11 ist jeweils durch eine Bohrung im Ring 6 geführt und ragt in eine darüberliegende, mit einer Führungsbuchse (nicht dargestellt) versehene Bohrung in der Basisplatte 4, wobei die lichte Weite der Bohrung den Durchmesser der Stütze 11 auf der entsprechenden Höhe deutlich übertrifft. Der auf der Stütze 11 abgestützte Zentrierstift 12 weist dagegen einen grösseren, nahezu der lichten Weite der zuletzt genannten Bohrung oder genauer der Führungsbuchse entsprechenden Durchmesser auf, so dass er in derselben zwar axial verschieblich, aber sonst im wesentlichen spielfrei geführt ist. Auf etwas mehr als halber Höhe ist am Zentrierstift 12 ein denselben umgebender Anschlagring 13 befestigt, dessen Unterseite einen die axiale Verschieblichkeit des Zentrierstifts 12 gegenüber der Basisplatte 4 begrenzenden Anschlag bildet.

Auf den Oberseiten der Anschlagringe 13 liegt ein Stützring 14 auf, welcher dort jeweils mit einer radialen, d. h. gegen das Zentrum des Rings gerichteten Nut versehen ist, welche den Anschlagring 13, dessen Dicke etwas grösser ist als die Tiefe der Nut, während deren Breite seinen Durchmesser übertrifft, zum Teil aufnimmt. Sie setzt sich jedoch nach oben in einem radial orientierten Langloch 15 fort, durch das der Zentrierstift: 12 azimutal im wesentlichen spielfrei durchgeführt ist, so dass der Stützring 14 durch die drei Zentrierstifte 12 im wesentlichen unverdrehbar und quer zur Achse 2 unverschiebbar fixiert ist. Zwischen dem einzelnen Zentrierstift 12 und dem Stützring 14 ist dagegen jeweils beschränkte radiale Bewegung möglich.

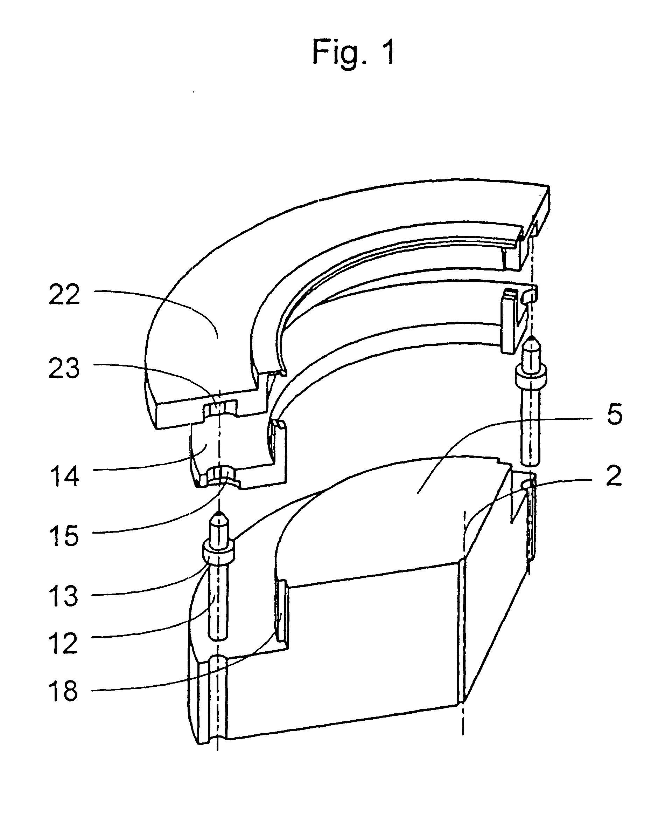

Der Stützring 14, der die Auflageplatte 5 mit etwas Abstand umgibt, weist in den azimutalen Positionen der Zentrierstifte 12 an seinem Innenrand drei nach oben weisende Stützen 16 auf, welche an den Innenseiten zur sicheren Aufnahme eines Werkstücks 17, das z. B. ein Wafer sein kann, mit Einsprüngen versehen sind. Die Stützen 16 liegen in entsprechenden Nuten 18 (Fig. 1), die in den Aussenrand der Auflageplatte 5 eingesenkt sind. Auch die Stützen 16 sind jedoch von derselben radial etwas beabstandet. Die Oberfläche der Auflageplatte 5 wird durch die Nuten 18 nur ganz geringfügig verkleinert. Es können auch mehr oder anders angeordnete Stützen vorgesehen sein oder auch eine einzige Stütze, welche die Auflageplatte durchgehend oder unterbrochen teilweise, z. B. hufeisenförmig umgibt.

Ausserhalb der Zentrierstifte 12, aber in den gleichen azimutalen Positionen sind Stehstifte 19 an der Wand 9 befestigt, auf denen ein Zwischenring 20 abgestützt ist. Und zwar weist derselbe an der Unterseite Nuten 21 auf, welche die Spitzen der Stehstifte 19 aufnehmen. Der Zwischenring 20 weist etwa L-förmigen Querschnitt auf mit einem nach innen weisenden Flansch, auf welchem in seiner Ruhelage ein Klemmring 22 aufliegt, der nach innen den Zwischenring 20 deutlich überragt und dort an der Unterseite ebenfalls radiale Nuten 23 aufweist, welche geeignet sind, die oberen Endbereiche der Zentrierstifte 12 aufzunehmen, und zwar ebenfalls so, dass jeweils radiale Bewegung möglich ist, aber quer dazu, azimutal, die Endbereiche im wesentlichen spielfrei in die Nuten 23 eingreifen. An der Innenseite weist der Klemmring 22 einen etwas nach oben abgesetzten Innenflansch 24 auf, welcher mit seinem leicht nach unten gebogenen, der Werkstückform folgenden, z. B. wie dargestellt kreisförmigen Rand die Stützen 16 übergreift. Statt eines geschlossenen Randes kann der Innenflansch allerdings auch einzelne Finger aufweisen. An seinem den Flansch umgebenden Aussenring trägt der Zwischenring 20 ein Schutzprofil 25, das mit einem nach innen weisenden Flansch den Klemmring 22 mit Ausnahme des Innenflansches 24 gegen oben abdeckt.

In der in Fig. 2 rechts dargestellten unteren Endposition der Haltevorrichtung kann mittels eines Laderoboters 26 das Werkstück 17 auf den Stützen 16 des Stützrings 14 bezüglich der Auflageplatte 5 zentriert abgelegt werden. Die Positioniergenauigkeit beträgt z. B. ±0,13 mm. Das Werkstück 17 ist dann mit entsprechender Genauigkeit gegenüber der Auflageplatte 5 zentriert. Nach dem Rückzug des Laderoboters 26 kann nun die Hubbewegung des Hubtisches 1 beginnen. Zuerst berührt dabei die Auflageplatte 5 die Unterseite des Werkstücks 17 und hebt es von den Stützen 16 des Stützrings 14 ab. Anschliessend erreicht die Basisplatte 4 den durch die Unterseiten der Anschlagringe 13 gebildeten Anschlag und die Zentrierstifte 12 werden bei der weiteren Hubbewegung mitgenommen. Da der Stützring 14 in seiner Ruhelage auf den Anschlagringen 13 aufliegt, wird er dabei von Anfang an mitgehoben. Der Anschlag zwischen der Basisplatte und den Anschlagringen kann auch so eingestellt sein, dass der Stützring bereits mitgenommen wird, wenn die Auflageplatte das Werkstück erreicht oder sich demselben bis auf einen vorgesehenen Mindestabstand genähert hat.

Im Laufe der weiteren Hubbewegung dringen die Zentrierstifte 12 in die Nuten 23 an der Unterseite des Klemmrings 22 ein, und zwar so weit, bis ihre oberen Endbereiche azimutal praktisch spielfrei, aber radial beweglich in denselben aufgenommen sind. Damit ist auch der Klemmring 22 bezüglich der Auflageplatte 5 zentriert. Kurz bevor ihre Spitzen jeweils den Grund der entsprechenden Nut 23 erreichen, stösst die Oberfläche des Werkstücks 17 an den Rand des Innenflansches 24 des Klemmrings 22, so dass derselbe aus seiner Ruhelage gehoben wird und, auf dem Werkstück 17 aufliegend, dasselbe bezüglich der Stützen 16 und der Auflageplatte 5 in seiner Position fixiert. Kurz nachher erreicht der Mitnehmerkragen 7 die Unterseite des Zwischenrings 20, worauf auch dieser bei der weiteren Hubbewegung mitgenommen wird. Reibungen beim Einbringen des Werkstücks 17 treten praktisch nur unterhalb desselben auf, so dass die Gefahr einer Verschmutzung durch Partikel sehr stark reduziert ist.

In der oberen Endposition (Fig. 2 links) der Haltevorrichtung hat nun das Werkstück 17 seine Bearbeitungsposition erreicht, in welcher seine Oberfläche durch z. B. Sputtern mit einer Schicht von beispielsweise Aluminium oder Siliziumdioxid bedeckt, geätzt oder sonstwie behandelt werden kann. Seine Unterseite kann dabei über die Auflageplatte 5 geheizt oder gekühlt werden, wobei durch die Leitung 10 Gas eingeleitet wird, das ein Gaspolster zwischen der Auflageplatte 5 und der Unterseite des Werkstücks 17 erzeugt, welches gleichmässige Wärmeübertragung gewährleistet.

Der Hubtisch 1 mit der Auflageplatte 5, der Stützring 14 mit den Scützen 16, der Klemmring 22 und der Zwischenring 20 mit dem Schutzprofil 25 sind vorzugsweise alle aus elektrisch leitendem. Material, insbesondere Metall hergestellt. Die Zentrierstifte 12 dagegen, durch welche diese Teile voneinander beabstandet sind, bestehen ebenso wie die (nicht dargestellten) Führungsbuchsen in der Basisplatte 4 vorzugsweise aus isolierendem, insbesondere keramischem Material, so dass die vorher genannten Teile alle gegeneinenander elektrisch isoliert sind und auf unterschiedlichen Potentialen gehalten werden können. Dies kann bei verschiedenen Bearbeitungsvorgängen zur Steuerung des elektrischen Feldes in der Prozesskammer benützt werden. Keramisches Material hat ausserdem einen geringen Gleitreibungskoeffizienten, sodass seine Verwendung für Führungsbuchsen oder Zentrierstifte oder beide überdies den Vorteil hat, dass diese wenig zur Partikelbildung beitragen. Sein geringer thermischer Ausdehnungskoeffizient gewährleistet. ausserdem eine weitgehende dimensionale Stabilität auch bei thermischer Belastung der Vorrichtung. Durch den weitgehend rotationssymmetrischen Aufbau der Haltevorrichtung und den koaxialen Leiteraufbau ist die Gefahr unkontrollierten Abfliessens von Strömen z. B. bei RF-Bias-Anwendungen sowie von Störfeldern auf Mess- und Regeleinheiten stark vermindert.

Nach dem Bearbeitungsvorgang wird die Haltevorrichtung wieder in die untere Endposition verbracht. Das Werkstück 17 befindet sich wieder in der Uebergabeposition und kann vom Laderoboter 26 aufgenommen und zurückgezogen werden.

Die Haltevorrichtung weist nur eine Antriebsachse auf, da alle Bewegungen durch Heben und Senken des Hubtisches 1 allein bewirkt werden. Sie ist dadurch mechanisch und steuerungstechnisch sehr einfach und benötigt wenig Wartung Es sind kurze Ladezeiten erreichbar, was den Durchsatz erhöht. Viele Teile sind nur aufgelegt und nicht weiter fixiert, so dass sie bei Bedarf leicht und rasch ausgewechselt werden können. Diese Eigenschaften der Haltevorrichtung wirken sich günstig auf die Verfügbarkeit der Vakuumanlage aus.

Da bei den Bearbeitungsvorgängen oft grosse Temperaturdifferenzen auftreten, ist es von grosser Bedeutung, dass bei der erfindungsgemässen Vorrichtung die gegenseitige Zentrierung der Auflageplatte 5, des Stützrings 14 und des Klemmrings 22 auch bei unterschiedlichen Wärmedehnungen dieser Teile erhalten bleibt. Dies wird dadurch erreicht, dass die Zentrierstifte 12 gegenüber dem Stützring 14 und dem Klemmring 22 radial jeweils ausreichend Spiel haben, aber mit allen genannten Teilen azimutal im wesentlichen spielfrei eingreifen. Bei einer Wärmedehnung der Basisplatte 4, die wegen des ausreichenden seitlichen Spiels der Stützen 11 durch dieselben nicht behindert wird, werden die Zentrierstifte 12 radial versetzt, was jedoch wegen der radialen Erstreckung der Nuten und der Langlöcher 15 im Stützring 14 und der Nuten 23 im Klemmring 22 dort nicht zu Schwierigkeiten führt, ebensowenig wie Wärmedehnungen der besagten Ringe. Die Kontaktstellen zwischen einem der Ringe und den Zentrierstiften 12 verschieben sich durch unterschiedliche Wärmedehnung radial auf dem Ring, während die Lage seines Zentrums sich nicht ändert. In prinzipiell gleicher Weise wie der Stützring 14 und der Klemmring 22 bezüglich der Achse 2 ist der Zwischenring 20 mit dem Schutzprofil 25 bezüglich einer ortsfesten Achse zentriert, die sich mit der Achse 2 deckt.

Im Grunde könnten die Auflageplatte, der Stützring und der Klemmring auch durch lediglich zwei Zentrierelemente in einer durch unterschiedliche Wärmedehnungen nicht beeinträchtigten Weise zentriert werden, sofern die durch dieselben und die Achse bestimmten Ebenen dort einen Winkel ≠180° einschliessen und die besagten Teile sonst, z. B. durch Ausbildung eines der Zentrierelemente als radial gerichtete Platte, gegen gegenseitige Verdrehung um eine vertikale Achse gesichert sind, doch bieten drei Zentrierelemente wie beschrieben zugleich eine Auflage für den Stützring 14, die seine Lage genau bestimmt. Es ist also von Vorteil, mindestens drei Zentrierelemente vorzusehen, die möglichst auch gleiche Abstände von der Achse aufweisen, obwohl letzteres nicht unbedingt nötig ist. Vorzugsweise bilden ihre Positionen ein regelmässiges Vieleck, insbesondere Dreieck, in dessen Zentrum die Achse liegt.

## Patentansprüche

1. Haltevorrichtung für den Transport eines Werkstücks (17) in einer Vakuumanlage, welche zwischen einer unteren Endstellung, in der das Werkstück (17) eingelegt oder entfernt werden kann und einer oberen Endstellung, in welcher das Werkstück (17) bearbeitet werden kann, umstellbar ist, mit einem hebund senkbaren Hubtisch (1) mit einer im wesentlichen der Form des Werkstücks (17) entsprechenden, um eine vertikale Achse (2) mindestens annähernd rotationssymmetrischen Auflageplatte (5), einem ebensolchen Stützring (14) zur Aufnahme des Werkstücks (17) in der unteren Endstellung und einem ebensolchen, oberhalb der Auflageplatte (5) angeordneten, vertikal verschiebbaren Klemmring (22) zum Festhalten des Werkstücks (17) in der oberen Endstellung, **dadurch gekennzeichnet, dass** sie zur Zentrierung des Stützrings (14) und des Klemmrings (22) bezüglich der Achse (2) eine mindestens in der oberen Endstellung mit dem Stützring (14) und dem Klemmring (22) sowie mit Teilen, die mit der Auflageplatte (5) fest verbunden sind, eingreifende Zentriervorrichtung aufweist mit mindestens zwei von der Achse (2) beabstandeten, mit ihr nicht beide in einer Ebene liegenden Zentrierelementen, welche mit den besagten Teilen, dem Stützring (14) und dem Klemmring (22) azimutal im wesentlichen spielfrei und mit mindestens zweien davon radial und axial verschieblich.eingreifen, wobei die Auflageplatte (5), der Stützring (14) und der Klemmring (22) zusätzlich gegen gegenseitige Verdrehung um die vertikale Achse (2) gesichert sind.

2. Haltevorrichtung nach Anspruch 1, **dadurch gekennzeichnet, dass** die Zentriervorrichtung als Zentrierelemente mindestens drei die Achse (2) umgebende Zentrierstifte (12) aufweist, welche jeweils. in einem der konzentrischen Teile radial unverschieblich verankert sind, während sie mindestens in der oberen Endstellung in radiale Schlitze oder Nuten der übrigen konzentrischen Teile eingreifen.

3. Haltevorrichtung nach Anspruch 2, **dadurch gekennzeichnet, dass** die Zentrierstifte (12) parallel zur Achse (2) ausgerichtet und von derselben gleich weit entfernt sind.

4. Haltevorrichtung nach Anspruch 2 oder 3, **dadurch gekennzeichnet, dass** der Stützring (14) vertikal verschiebbar ist und mit dem Hubtisch (1) derart in Wirkverbindung steht, dass er von dessen Hubbewegung nach Beginn derselben mitgenommen wird.

5. Haltevorrichtung nach Anspruch 4, **dadurch gekennzeichnet, dass** die Zentrierstifte (12) in der unteren Endstellung ortsfest abgestützt sind und im Hubtisch (1) axial verschiebbar, aber sonst im wesentlichen spielfrei geführt und durch den Stützring (14) mindestens axial und radial verschieblich durchgeführt sind und dass ihre Beweglichkeit gegenüber dem Hubtisch (1) nach unten und gegenüber dem Stützring (14) nach oben jeweils durch einen Anschlag begrenzt ist.

6. Haltevorrichtung nach Anspruch 5, **dadurch gekennzeichnet, dass** der Stützring (14) radiale Langlöcher (15) zur mindestens azimutal im wesentlichen spielfreien Aufnahme der Zentrierstifte (12) aufweist.

7. Haltevorrichtung nach Anspruch 5 oder 6, **dadurch gekennzeichnet, dass** die Anschläge jeweils durch die Oberseite bzw. Unterseite eines den Zentrierstift (12) umgebenden Anschlagrings (13) gebildet werden.

8. Haltevorrichtung nach einem der Ansprüche 2 bis 7, **dadurch gekennzeichnet, dass** der Klemmring (22) an seiner Unterseite radiale Nuten (23) aufweist, in welche mindestens in der Bearbeitungsposition die Spitzen der Zentrierstifte (12) azimutal im wesentlichen spielfrei eingreifen.

9. Haltevorrichtung nach Anspruch 8, **dadurch gekennzeichnet, dass** der Stützring (14) mindestens drei nach oben abstehende Stützen (16) zur Aufnahme des Werkstücks (17) aufweist und der Klemmring (22) einen nach innen weisenden, die Stützen (16) übergreifenden Innenflansch (24) mit nach unten gebogenem Innenrand aufweist.

10. Haltevorrichtung nach einem der Ansprüche 1 bis 9, **dadurch gekennzeichnet, dass** die Stützen (16) mindestens in der oberen Endstellung in vertikalen Nuten (18) liegen, welche in den Rand der Auflageplatte (5) eingesenkt sind.

11. Haltevorrichtung nach einem der Ansprüche 1 bis 10, **dadurch gekennzeichnet, dass** der Klemmring (22) in einer Ruhelage, aus der er durch Kontakt mit dem Werkstück (17) bei der Hubbewegung des Hubtisches (1) abgehoben wird, auf einem Zwischenring (20) aufliegt, welcher ortsfest abgestützt ist.

12. Haltevorrichtung nach Anspruch 11, **dadurch gekennzeichnet, dass** die Abstützung des Zwischenrings (20) in seiner Ruhelage durch vertikale Stehbolzen (19) erfolgt, welche die Achse (2) umgeben und deren Spitzen in radiale Nuten (21) an seiner Unterseite eingreifen, so däss er zugleich bezüglich der Achse (2) zentriert ist.

13. Haltevorrichtung nach Anspruch 11 oder 12, **dadurch gekennzeichnet, dass** der Zwischenring (20) ein Schutzprofil (25) trägt, welches den Klemmring (22) mindestens teilweise gegen oben abdeckt.

14. Haltevorrichtung nach einem der Ansprüche 11 bis 13, **dadurch gekennzeichnet, dass** der Hubtisch (1) einen Mitnehmer (7) aufweist, welcher bei der Hubbewegung den Zwischenring (20) mitnimmt.

15. Haltevorrichtung nach einem der Ansprüche 1 bis 14, **dadurch gekennzeichnet, dass** die Auflageplatte (5), der Stützring (14) und der Klemmring (22) jeweils aus elektrisch leitendem Material bestehen und mindestens in der oberen Endstellung voneinander beabstandet und elektrisch isoliert sind.

16. Haltevorrichtung nach Anspruch 13, oder Anspruch 14 mit Anspruch 13, oder Anspruch 15 mit Anspruch 13, **dadurch gekennzeichnet, dass** mindestens in der oberen Endstellung das Schutzprofil (25) von der Auflageplatte (5), vom Stützring (14) und vom Klemmring (22) beabstandet und elektrisch isoliert ist.

17. Haltevorrichtung nach Anspruch einem der Ansprüche 2 bis 16, **dadurch gekennzeichnet, dass** die Zentrierstifte (12) in den Eckpunkten eines regelmässigen Vielecks angeordnet sind.

18. Haltevorrichtung nach einem der Ansprüche 2 bis 17, **dadurch gekennzeichnet, dass** die Zentrierstifte (12) aus keramischem Material bestehen.

## Claims

1. Holding device for transporting a workpiece (17) in a vacuum unit, which can be transferred between a lower end position, in which the workpiece (17) can be inserted or removed, and an upper end position, in which the workpiece (17) can be processed, comprising a raisable and lowerable lifting table (1) having a support plate (5), corresponding essentially to the shape of the workpiece (17) and in particular at least approximately rotationally symmetrical about a vertical axis (2), a support ring (14) for holding the workpiece (17) in the lower end position and a vertically displaceable clamping ring (22) arranged above the support plate (5) and intended for retaining the workpiece (17) in the upper end position, **characterized in that**, for centring the support ring (14) and the clamping ring (22) relative to the axis (2), it has a centring device engaging the supporrt ring (14) and the clamping ring (22) as well as parts fixedly connected to the support plate (5) at least in the upper end position and having at least two centring elements which are a distance away from the axis (2), are not both present together with it in a plane and are essentially without play azimuthally relative to said parts, the support ring (14) and the clamping ring (22) and engage at least two thereof in a radially and axially displaceable manner, the support plate (5), the support ring (14) and the clamping ring (22) additionally being secured to prevent mutual rotation about the vertical axis (2).

2. Holding device according to Claim 1, **characterized in that** the centring device has, as centring elements, at least three centring pins (12) which surround the axis (2) and which in each case are radially and nondisplaceably anchored in one of the concentric parts while, at least in the upper end position, they engage radial slots or grooves in the other concentric parts.

3. Holding device according to Claim 2, **characterized in that** the centring pins (12) are oriented parallel to the axis (2) and are equal distances away therefrom.

4. Holding device according to Claim 2 or 3, **characterized in that** the support ring (14) is vertically displaceable and cooperates with the lifting table (1) in such a way that it is carried along by its lifting movement after the beginning of the latter.

5. Holding device according to Claim 4, **characterized in that** the centring pins (12) are supported in a fixed location in the lower end position and are guided in the lifting table (1) in an axially displaceable manner but otherwise essentially without play and are passed through the support ring (14) at least in an axially and radially displaceable manner, and that their mobility in a downward direction with respect to the lifting table (1) and in an upward direction with respect to the support ring (14) is limited in each case by a stop.

6. Holding device according to Claim 5, **characterized in that** the support ring (14) has radial slots (15) for receiving the centring pins (12) essentially without play at least azimuthally.

7. Holding device according to Claim 5 or 6, **characterized in that** the stops are each formed by the top or underside of a stop ring (13) surrounding the centring pin (12).

8. Holding device according to any of Claims 2 to 7, **characterized in that** the clamping ring (22) has, in its underside, radial grooves (23) which, at least in the processing position, are engaged by the tips of the centring pins (12) essentially without play azimuthally.

9. Holding device according to Claim 8, **characterized in that** the support ring (14) has at least three upward-projecting supports (16) for holding the workpiece (17) and the clamping ring (22) has an inward-pointing inner flange (24) which overlaps the supports (16) and has an inner edge bent downwards.

10. Holding device according to any of Claims 1 to 9, **characterized in that** the supports (16), at least in the upper end position, rest in vertical grooves (18) which are let into the edge of the support plate (5).

11. Holding device according to any of Claims 1 to 10, **characterized in that** the clamping ring (22), in a rest position from which it is raised by contact with the workpiece (17) during the lifting movement of the lifting table (1), rests on an intermediate ring (20) which is supported in a fixed location.

12. Holding device according to Claim 11, **characterized in that** the intermediate ring (20) is supported in its rest position by vertical pins (19) which surround the axis (2) and whose points engage radial grooves (21) in the underside of said intermediate ring, so that it is centred relative to the axis (2) at the same time.

13. Holding device according to Claim 11 or 12, **characterized in that** the intermediate ring (20) carries a protective profile (25) which at least partly covers the top of the clamping ring (22).

14. Holding device according to any of Claims 11 to 13, **characterized in that** the lifting table (1) has a driver (7) which carries along the intermediate ring (20) during the lifting movement.

15. Holding device according to any of Claims 1 to 14, **characterized in that** the support plate (5), the support ring (14) and the clamping ring (22) each consist of electrically conducting material and are a distance apart at least in the upper end position and are electrically isolated.

16. Holding device according to Claim 13 or Claim 14 together with Claim 13 or Claim 15 together with Claim 13, **characterized in that**, at least in the upper end position, the protective profile (25) is a distance away from the support plate (5), from the support ring (14) and from the clamping ring (22) and is electrically isolated.

17. Holding device according to Claim [sic] any of Claims 2 to 16, **characterized in that** the centring pins (12) are arranged at the vertices of a regular polygon.

18. Holding device according to any of Claims 2 to 17, **characterized in that** the centring pins (12) consist of ceramic material.

## Revendications

1. Dispositif de retenue pour le transport d'une pièce à usiner (17) dans un appareil à vide réglable entre une position finale inférieure, qui permet l'insertion ou le retrait de la pièce à usiner (17) et une position finale supérieure, qui permet l'usinage de la pièce à usiner (2), avec une table élévatrice (1) pouvant être relevée ou abaissée, avec une plaque support (5) correspondant pour l'essentiel à la forme de la pièce à usiner (17) située autour d'un axe (2) vertical présentant essentiellement une symétrie rotationnelle, une bague de support (14) du même type dédiée à la réception de la pièce à usiner (17) en position finale inférieure et une bague de bridage (22) du même type, disposée au-dessus de la plaque support (5) et verticalement mobile dédiée à la retenue de la pièce à usiner (17) en position finale supérieure, **caractérisé en ce qu'**il présente un dispositif de centrage s'engrenant au moins en position finale supérieure avec la bague de support (14), la bague de bridage (22) et des parties qui sont liées fixement à la plaque support (5) pour le centrage de la bague de support (14) et de la bague de bridage (22) relativement à l'axe (2) avec au moins deux éléments de centrage distants de l'axe (2) et ne se trouvant pas tous deux sur le même plan que ce dernier, lesquels venant en prise avec lesdites parties, la bague de support (14) et la bague de bridage (22) essentiellement sans jeu azimutalement et avec deux d'entre eux au moins venant en prise de manière mobile radialement et axialement, la plaque support (5), la bague de support (14) et la bague de bridage (22) étant en outre protégées contre les rotations réciproques autour de l'axe vertical (2).

2. Dispositif de retenue selon la revendication 1, **caractérisé en ce que** le dispositif de centrage présente au moins trois tiges de centrage (12) faisant office d'éléments de centrage; ces dernières entourent l'axe (2) et sont montées radialement de manière fixe dans l'un des éléments concentriques, tandis qu'elles viennent en prise au moins en position finale supérieure dans des fentes ou des rainures radiales des autres éléments concentriques.

3. Dispositif de retenue selon la revendication 2, **caractérisé en ce que** les tiges de centrage (12) sont orientées parallèlement à l'axe (2) et sont également directement distantes de ce dernier.

4. Dispositif de retenue selon les revendications 2 et 3, **caractérisé en ce que** la bague de support (14) est mobile verticalement et se trouve en liaison active avec la table élévatrice (1) de telle sorte qu'elle est entraînée dès le début par le mouvement de levage de cette dernière.

5. Dispositif de retenue selon la revendication 4, **caractérisé en ce que** les tiges de centrage (12) sont appuyées fixement en position finale inférieure et sont mobiles axialement mais en outre essentiellement sans jeu dans la table élévatrice (1) et sont introduites de manière mobile à travers la bague de support (14) au moins axialement et radialement et, **en ce que** leur mobilité par rapport à la table élévatrice (1) est limitée vers le bas et par rapport à la bague de support (14) vers le haut en tout cas par une butée.

6. Dispositif de retenue selon la revendication 5, **caractérisé en ce que** la bague de support (14) présente des trous oblongs radiaux (15) dédiés à la réception essentiellement au moins sans jeu azimutalement des tiges de centrage (12).

7. Dispositif de retenue selon la revendication 5 ou 6, **caractérisé en ce que** les butées sont formées respectivement par la face supérieure ou la face inférieure d'une bague de butée (13) qui entoure la tige de centrage (12).

8. Dispositif de retenue selon l'une des revendications 2 à 7, **caractérisé en ce que** la bague de bridage (22) présente des rainures radiales (23) sur sa face inférieure dans lesquelles les pointes des tiges de centrage (12) s'engrènent essentiellement sans jeu azimutalement dans la position d'usinage.

9. Dispositif de retenue selon la revendication 8, **caractérisé en ce que** la bague de support (14) présente au moins trois étais (16) pointant vers le haut dédiés à la réception de la pièce à usiner (17) et **en ce que** la bague de bridage (22) présente une bride intérieure orientée vers l'intérieur (24) et dépassant des étais (16) avec un bord intérieur recourbé vers le bas.

10. Dispositif de retenue selon l'une des revendications 1 à 9, **caractérisé en ce que** les étais (16) se trouvent au moins en position finale supérieure dans des rainures verticales (18) gravées dans le bord de la plaque support (5).

11. Dispositif de retenue selon les revendications 1 à 10, **caractérisé en ce que** la bague de bridage (22) en position de repos, qu'elle quitte en entant en contact avec la pièce à usiner (17) lors du mouvement de levage de la table élévatrice (1), s'appuie sur la bague intermédiaire (20) fixe.

12. Dispositif de retenue selon la revendication 11, **caractérisé en ce que** l'étayage de la bague intermédiaire (20) dans sa position de repos est assuré par des vis sans tête verticales (19) qui entourent l'axe (2) et dont les pointes s'engrènent dans les fentes radiales (21) au niveau de sa face inférieure, de manière à ce qu'elle soit dans le même temps centré relativement à l'axe (2).

13. Dispositif de retenue selon la revendication 11 ou 12, **caractérisé en ce que** la bague intermédiaire (20) est dotée d'un profil de protection (25) qui couvre au moins partiellement la bague de bridage (22) vers le haut.

14. Dispositif de retenue selon l'une des revendications 11 à 13, **caractérisé en ce que** la table élévatrice (1) présente un collier d'entraînement (7) qui entraîne la bague intermédiaire (20) lors du mouvement de levage.

15. Dispositif de retenue selon l'une des revendications 1 à 14, **caractérisé en ce que** la plaque support (5), la bague de support (14) et la bague de bridage (22) se composent respectivement de matériaux électriques conducteurs et sont au moins distants les uns des autres en position finale supérieure ainsi qu'isolés électriquement.

16. Dispositif de retenue selon la revendication 13, ou la revendication 14 avec la revendication 13, ou la revendication 15 avec la revendication 13, **caractérisé en ce que** le profil de protection (25) est distant et isolé électriquement de la plaque support (5), de la bague de support (14) et de la bague de bridage (22) au moins en position finale supérieure.

17. Dispositif de retenue selon l'une des revendications 2 à 16, **caractérisé en ce que** les tiges de centrage (12) sont disposées de manière à former les coins d'un polygone régulier.

18. Dispositif de retenue selon l'une des revendications 2 à 17, **caractérisé en ce que** les tiges de centrage (12) sont constituées de matériaux céramiques.
